Europäisches Patentamt

European Patent Office

Office européen des brevets

(19)

(11) EP 1 207 297 A2

(12) **EUROPÄISCHE PATENTANMELDUNG**

(43) Veröffentlichungstag:
22.05.2002 Patentblatt 2002/21

(51) Int Cl.$^7$: **F02N 11/08**

(21) Anmeldenummer: 01125295.4

(22) Anmeldetag: 25.10.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **17.11.2000 DE 10056970**

(71) Anmelder: **ROBERT BOSCH GMBH**
**70442 Stuttgart (DE)**

(72) Erfinder: **Schoch, Eberhard**
**70469 Stuttgart (DE)**

(54) **Verfahren und Anordnung zur Ermittlung der Startfähigkeit einer Starterbatterie eines Verbrennungsmotors**

(57) Verfahren zur Bestimmung der Startfähigkeit einer Starterbatterie eines Verbrennungsmotors mit folgenden Schritten:

- Feststellung eines die Startfähigkeit beeinflussenden Ladezustands soc der Starterbatterie,
- Feststellung einer die Startfähigkeit beeinflussenden Temperatur, insbesondere der Temperatur der Starterbatterie $T_{Batt}$,
- Berechnung oder Feststellung eines mittleren Spannungsabfalls $\Delta U_{Batt, mitt}$ der Starterbatterie während einer Startphase, insbesondere während einer Durchdrehphase eines mit der Starterbatterie in Wirkverbindung stehenden Startermotors, und
- Abschätzung der Startfähigkeit der Starterbatterie durch Vergleich des berechneten oder festgestellten mittleren Spannungsabfalls $\Delta U_{Batt, mitt}$ mit einem Schwellwert $\Delta U_{Batt, min}$.

FIG. 1

Ist Kaltstart beabsichtigt ? — 101

Ermittlung von Klemmenspannung oder Ruhespannung $U_0$ der unbelasteten Batterie — 102

Kaltstart einleiten — 103

Erreicht Startermotor Durchdrehphase ? — 104

Bilde Differenz aus Ruhespannung $U_0$ und aktueller Klemmenspannung $U_{Batt, i}$ zu Zeitpunkt i ( i = 1,....n ) — 105

Durchdrehphase des Startermotors beendet ? — 106
Nein
Ja

Berechne $U_{Batt, mitt} = \frac{1}{n}\sum ( U_0 - U_{Batt, i} )$ — 107

Vergleich $U_{Batt, mitt}$ mit Schwellwert — 108

Stelle Startfähigkeit der Batterie fest — 109

EP 1 207 297 A2

**Beschreibung**

Gebiet der Erfindung

Die vorliegende Erfindung betrifft ein Verfahren zur Ermittlung der Startfähigkeit einer Starterbatterie eines Verbrennungsmotors sowie eine entsprechende Anordnung.

Stand der Technik

In einem Kraftfahrzeug (oder einem anderen primär aus einem Verbrennungsmotor mit Energie versorgten System) ist die Funktionsfähigkeit der Starterbatterie des Verbrennungsmotors eine der wichtigsten Voraussetzungen für die Sicherstellung der Betriebsfähigkeit. Üblicherweise wird der Verbrennungsmotor durch einen elektrischen Anlasser gestartet, welcher die Energie für den Startvorgang aus einer Starterbatterie bezieht. Der Anlasser muss dazu für kurze Zeit ein Drehmoment aufbringen, welches in der Lage ist, den Verbrennungsmotor bei einer gewissen Mindestdrehzahl durchzudrehen. Dazu muss durch den Anlasser ein genügend großer Strom fließen bzw. eine ausreichend hohe Spannung anliegen. Ist die Starterbatterie sehr kalt, teilweise entladen oder stark gealtert, kann der Innenwiderstand der Batterie so hoch werden, dass Strom und Spannung nicht in ausreichendem Maße zur Verfügung stehen, um den Startvorgang sicherzustellen. Eine derartige Problematik ist beispielsweise in der DE 197 05 634 C2 beschrieben.

Sind beispielsweise die Leerlaufspannung und der Innenwiderstand einer Starterbatterie bekannt, kann bei gegebenen Startstrom und gegebener Starttemperatur die Startfähigkeit der Starterbatterie geprüft werden. Zu diesem Zweck ist es möglich, die Klemmenspannung aus den bekannten Größen zu berechnen und mit der für das Erreichen der Startdrehzahl benötigen Mindestspannung zu vergleichen. Dies ist z. B. wichtig, um bei Start-Stopp-Systemen die Startfähigkeit zu gewährleisten, indem rechtzeitig vor Erreichen der Startgrenze der Motor gestartet wird, um dadurch die Batterie über den Generator nachzuladen.

Da der Innenwiderstand der Starterbatterie außer vom Ladezustand und der Temperatur auch von dem Batteriealter abhängt, muss er in regelmäßigen Abständen neu ermittelt werden. Um nur den für den Start maßgeblichen Ohmschen Widerstand der Elektroden und des Elektrolyten zu erhalten, bietet sich die Berechnung des Innenwiderstandes aus dem Spannungseinbruch und dem maximalen Strom beim Start an. Problematisch hierbei sind jedoch der zu diesem Zwecke benötigte große Strommessbereich bis über 1 kA und die hohen auftretenden Stromgradienten von bis zu 1 kA/msec. Dies stellt erhöhte Anforderungen an die Stromsensorik in einem Batterie-Management-System, und führt evtl. zur Notwendigkeit eines zusätzlichen Sensors für diesen hohen Strommessbereich.

Mit der Erfindung wird eine möglichst einfache Bestimmung der Startfähigkeit einer Starterbatterie, bei welcher eine Bestimmung eines Startstroms der Batterie nicht notwendig ist, angestrebt.

Darstellung der Erfindung

Dieses Ziel wird erreicht durch ein Verfahren mit den Merkmalen des Patentanspruchs 1 sowie eine Anordnung mit den Merkmalen des Patentanspruchs 6.

Erfindungsgemäß ist nun eine Bestimmung der Startfähigkeit einer Starterbatterie eines Verbrennungsmotors ohne Bestimmung bzw. Berechnung eines Startstroms der Batterie möglich. Dadurch kann im Falle von Batterie-Management-Systemen, die zur Ladezustandsbestimmung den Batteriestrom sensieren, der Strommessbereich gegenüber herkömmlichen Lösungen stark eingeschränkt werden, da erfindungsgemäß auf die Erfassung der üblicherweise geringen Ladungsentnahme beim Start verzichtet werden kann.

Die Erfindung nutzt zur Bestimmung der Startfähigkeit den mittleren Spannungsabfall in der Starterbatterie während des Starts anstelle von Innenwiderstand und Startstrom der Batterie. Hierdurch kann auch auf eine aufwendige Sensorik für eine Startstrommessung verzichtet werden.

Vorteilhafte Ausgestaltungen der Erfindung sind Gegenstand der Unteransprüche.

Gemäß einer bevorzugten Ausgestaltung des erfindungsgemäßen Verfahrens wird der Vergleich des erfindungsgemäß berechneten mittleren Spannungsabfalls mit einem Schwellwert unter Zuhilfenahme einer Beziehung der Form

$$U_0(\text{soc}, T_{Batt}) - \Delta U_{Batt,\ mitt}(\text{soc}, T_{Batt}) = U_{Batt,\ min}$$

ermittelt, wobei soc der Ladezustand der Starterbatterie, $T_{Batt}$ die Temperatur der Batterie, $U_0$ die Ruhespannung der Batterie, $\Delta U_{Batt,\ mitt}$ der mittlere Spannungsabfall in der Batterie während einer Startphase, und $U_{Batt,\ min}$ die als Schwellwert einsetzbare Mindestspannung zur Erreichung der Startdrehzahl der Starterbatterie ist. Üblicherweise ist es möglich, die Mindestspannung $U_{Batt, min}$ als bekannt vorauszusetzen, wobei der Ladezustand soc vom Batteriemanagement geliefert wird. Auf der Grundlage der genannten Gleichung ist es alternativ möglich, durch Auflösung der Gleichung nach soc auch den Mindestladezustand für einen erfolgreichen Start bei gegebener Starttemperatur zu ermitteln.

Gemäß einer weiteren bevorzugten Ausführungsform des erfindungsgemäßen Verfahrens wird der mittlere Spannungsabfall gemäß einer Gleichung

$$\Delta U_{Batt, mitt} (soc, T_{Batt}) = 1/n * \Sigma (U_0 (soc, T_{Batt}) - U_{Batt, i})$$

$$i=1..n$$

zu Zeitpunkten i = 1.... n während der Durchdrehphase des Startermotors berechnet. Hierdurch erhält man eine Mittelwertbildung, welche eine zuverlässige Abschätzung der Startfähigkeit einer Starterbatterie ermöglicht.

Zweckmäßigerweise wird die Ruhespannung $U_0$ der Batterie bei bekanntem Ladezustand gemäß einer Gleichung der Form

$$U_0(soc, T_{Batt}) = 6*(1.88+0{,}247*soc+(T_{Batt}-25)*0{,}23e-3)$$

bei bekanntem Ladezustand und bekannter Batterietemperatur und/oder aus der Klemmenspannung der unbelasteten Batterie unmittelbar vor dem Start des Verbrennungsmotors ermittelt.

Gemäß einer weiteren bevorzugten Ausführungsform des erfindungsgemäßen Verfahrens wird auf der Grundlage der ermittelten mittleren Spannungsabfallwerte $\Delta U_{Batt,mitt}$ ein Kennfeld für die mittleren Spannungsabfallwerte in Abhängigkeit von Batterieladezuständen und Batterietemperaturen erstellt und gespeichert. Ein derartiges Kennfeld erlaubt es, auf der Grundlage der Messung bzw. Feststellung von Batterieladezustand bzw. Batterietemperatur durch entsprechende Inter- bzw. Extrapolation auf tatsächliche mittlere Spannungsabfallwerte zu schließen, ohne dass die oben angeführten Gleichungen konkret berechnet werden müssen.

## Zeichnung

Die Erfindung wird nun anhand bevorzugter Ausführungsbeispiele unter Bezugnahme auf die beigefügte Zeichnung weiter beschrieben. In dieser zeigt:

Figur 1    ein schematisch vereinfachtes Flussdiagramm zur Erläuterung des erfindungsgemäßen Verfahrens,

Figur 2    ein erfindungsgemäß erstellbares und speicherbares Kennfeld für mittlere Abspannungsabfallwerte in Abhängigkeit von Batterietemperatur und Batterieladezustand, und

Figur 3    ein stark vereinfachtes Diagramm zur Darstellung wesentlicher Komponenten der erfindungsgemäßen Anordnung.

## Beschreibung der Ausführungsbeispiele

Grundlage des erfindungsgemäßen Verfahrens ist, dass die Startfähigkeit einer Starterbatterie unter Zugrundelegung des mittleren Spannungsabfalls während der Durchdrehphase eines mit der Starterbatterie in Wirkverbindung stehenden Startermotors des Verbrennungsmotors über die Bedingung

$$U_0(soc, T_{Batt}) - \Delta U_{Batt, mitt} (soc, T_{Batt}) = U_{Batt, min} \tag{1}$$

bei bekanntem Ladezustand und bekannter Batterietemperatur geprüft wird. Eine Mindestbatteriespannung $U_{Batt, min}$ wird hierbei als bekannt vorausgesetzt, während der Ladezustand soc vom Batteriemanagement geliefert wird.

Bei bekanntem Ladezustand kann $U_0$ gemäß der Gleichung

$$U_0(soc, T_{Batt}) = 6*(1.88+0.247*soc+(T_{Batt}-25)*0.23e-3) \tag{2}$$

oder alternativ aus der Klemmenspannung der unbelasteten Batterie unmittelbar vor dem Start bestimmt werden.

Da der Spannungsabfall $\Delta U_{Batt}$ in der Batterie beim Start nährungsweise dem Produkt aus Batterieinnenwiderstand und Starterstrom entspricht, wirken sich auf diesen Spannungsabfall neben dem Batterieladezustand und der Batterietemperatur auch Alterungseffekte von Batterie, Starter und Verbrennungsmotor aus, so dass die jeweiligen Werte $\Delta U_{Batt, mitt}$ (soc, $T_{Batt}$) bzw. ein auf der Grundlage dieser Werte generiertes Kennfeld während des Betriebes adaptiert werden muss. Da der Starterstrom u.a. von der Motortemperatur abhängt, gilt Gleichung (1) nur im Falle eines Kaltstarts, d.h. wenn Motor und Batterie zunächst Umgebungstemperatur annehmen, genau. Im Falle eines Warmstarts sind entsprechende Modifikationen durchführbar, welche an sich bekannt sind und die grundliegende Idee der vorliegenden Erfindung nicht betreffen.

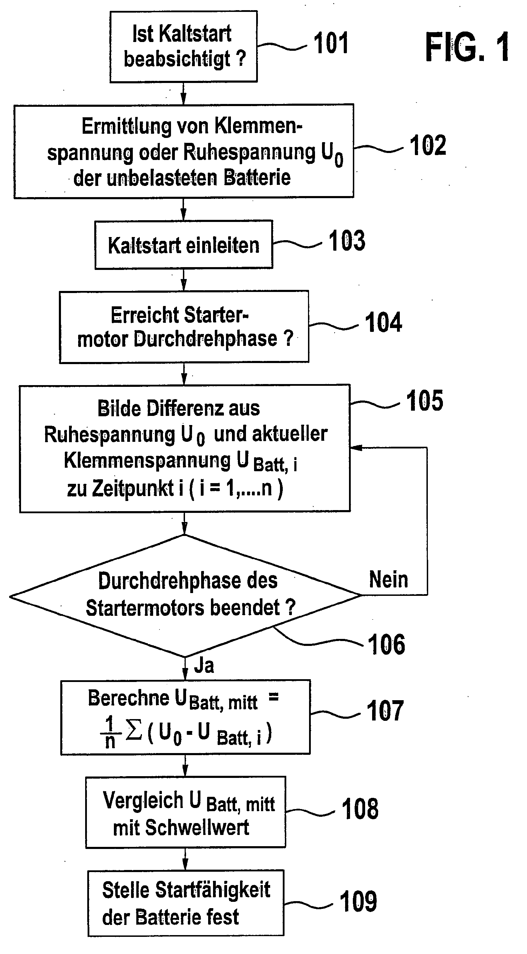

Das erfindungsgemäße Verfahren wird nun beispielhaft für den Fall eines Kaltstarts anhand der Fig. 1 weiter erläutert. In einem Schritt 101 wird zunächst festgestellt, ob ein Kaltstart des Verbrennungsmotors beabsichtigt ist. Dies kann beispielsweise über eine Feststellung einer Drehung eines Zündschlüssels ermittelt werden. In einem Schritt 102 wird anschließend die Klemmenspannung bzw. Ruhespannung $U_0$ der noch unbelasteten Batterie ermittelt. Anschließend wird in einem Schritt 103 der Beginn des Kaltstarts durch Betätigung eines Startermotors bzw. Anlassermotors in an sich bekannter Weise eingeleitet. In einem Schritt 104 wird überprüft, ob der Startermotor seine Durchdrehphase erreicht hat. Wenn festgestellt wird, dass dies der Fall ist, wird zu einem ersten Zeitpunkt i = 1 die Differenz aus Ruhespannung $U_0$ und der aktuellen Klemmenspannung der Batterie zum Zeitpunkt i = 1, $U_{Batt,i=1}$, berechnet und in einem geeigneten Speicher abgelegt. In einem anschließenden Schritt 106 wird festgestellt, ob die Drehphase beendet worden ist oder nicht. Ist die Drehphase noch nicht beendet, verzweigt das Verfahren zurück zu Schritt 105, wobei die Differenz $U_0 - U_{Batt, i}$ für einen Zeitpunkt i = 2 berechnet wird. Die erläuterte Verzweigung zwischen Schritten 105 und 106 findet so lange statt, bis in Schritt 106 festgestellt wird, dass die Drehphase des Startermotors beendet wurde. Bei sukzessivem Durchlaufen des Schrittes 105 erfolgt die erwähnte Differenzbildung zu Zeiten i = 1, 2, ... n, wobei die Intervalle zwischen den Zeitpunkten i zweckmäßigerweise gleich groß sind.

Ist in Schritt 106 das Ende der Durchdrehphase festgestellt worden, wird in einem anschließenden Schritt 107 der Wert $U_{Batt, mitt}$ gemäß einer Gleichung der Form

$$\Delta U_{Batt, mitt} (soc, T_{Batt}) = 1/n * \Sigma (U_0(soc, T_{Batt}) - U_{Batt, i}) \tag{3}$$

berechnet. In einem anschließenden Schritt 108 wird auf der Grundlage der Gleichung (1) ein Vergleich des gemäß Gleichung (3) berechneten Wertes $\Delta U_{Batt, mitt}$ mit der als bekannt vorausgesetzten Mindestspannung zum Erreichen der Startdrehzahl des Startermotors, $U_{Batt, min}$, durchgeführt. Fällt dieser Vergleich positiv aus, d.h. der mittlere Spannungsabfall übersteigt einen bestimmten Schwellwert nicht, wird in einem Schritt 109 die Startfähigkeit der Starterbatterie festgestellt. Liegt der mittlere Spannungsabfall jedoch über diesem Schwellwert, wird in Schritt 109 die nichtvorhandene Startfähigkeit der Batterie festgestellt. Im letzteren Fall ist es zweckmäßig, an sich bekannt Maßnahmen einzuleiten, um einen Start des mit der Batterie in Wirkverbindung stehenden Verbrennungsmotors dennoch zu ermöglichen. Als Maßnahmen seien insbesondere genannt eine Modifizierung des Energiemanagements, beispielsweise durch Abschalten von Verbrauchern, welche für den Start des Verbrennungsmotors nicht notwendig sind, oder Aufladung der Starterbatterie mittels einer gegebenenfalls vorhandenen Speicherbatterie. Wird festgestellt, dass die Startfähigkeit im Grenzbereich liegt, kann durch geeignete Maßnahmen, beispielsweise Erhöhung der Leerlaufdrehzahl des Verbrennungsmotors, eine Regenerierung der Starterbatterie gefördert werden.

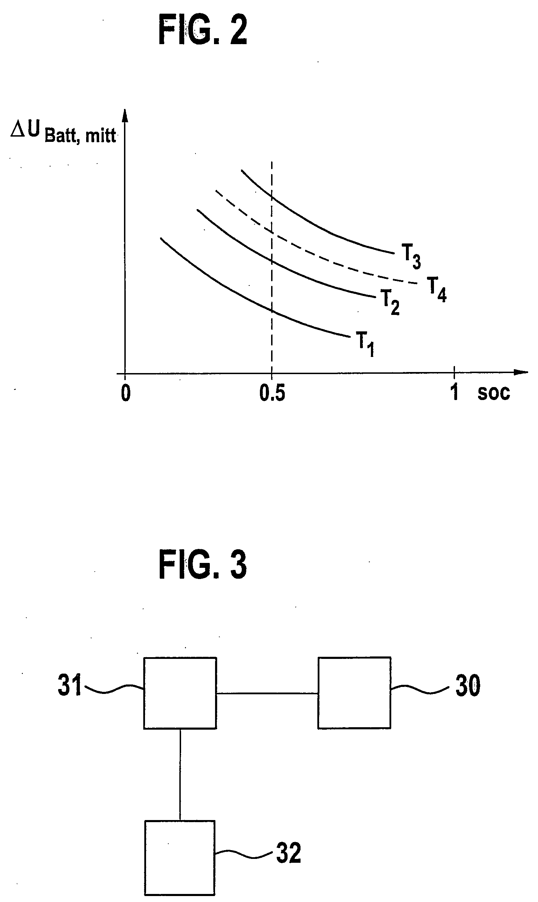

Mittels Durchführung des erläuterten Verfahrens für eine Vielzahl von Batterietemperaturen bzw. Ladungszuständen der Batterie ist es möglich, ein entsprechendes Kennfeld $\Delta U_{Batt, mitt}$(soc, $T_{Batt}$) zu generieren. Bei einem ausreichend genau bekannten Kennfeld ist es möglich, die Startfähigkeit für einen gegebenen Ladezustand soc und eine gegebene Batterietemperatur $T_{Batt}$ bzw. einen entsprechenden mittleren Spannungsabfall $\Delta U_{Batt, mitt}$ aus den gemessenen Kennfeldpunkten durch Inter- bzw. Extrapolation abzuleiten, wobei dann auf eine konkrete Durchführung der Berechnungen nach Gleichungen (1) und (3) verzichtet werden kann. Ein typisches Kennfeld $\Delta U_{Batt, mitt}$(soc, $T_{Batt}$) ist, schematisch vereinfacht, in Figur 2 dargestellt. Man erkennt, dass mit zunehmender Batterieladung bzw. besserem Batterieladungszustand soc für eine konkrete Temperatur mit einer Abnahme des mittleren Spannungsabfalls in der Batterie während der Startvorgangs zu rechnen ist. Wird beispielsweise festgestellt, dass ein Batterieladezustand soc = 0,5, und eine Temperatur T4 zwischen T2 und T3 vorliegt, kann durch entsprechende Interpolation (gestrichelt angedeutet) auf einen konkret bei den genannte Bedingungen vorliegenden mittleren Spannungsabfall geschlossen werden.

Zur Vereinfachung der Inter- bzw. Extrapolation kann die Abhängigkeit des mittleren Spannungsabfalls vom Ladezustand soc separiert werden, da dieser auf die ladezustandsabhängige Leitfähigkeit des in der Batterie verwendeten Elektrolyten zurückzuführen ist, für die im Bereich soc > 0,5 folgende Proportionalität angegeben werden kann:

$$\text{Leitfähigkeit} \sim (3.012 * soc - 2.011 * soc^2). \tag{4}$$

Damit kann $\Delta U_{Batt, mitt}$ für verschiedene Ladezustände gemäß

$$\Delta U_{Batt, mitt} (soc, T_{Batt}) =$$

$$(3.012 * soc_0 - 2.011 * soc^2)/(3.012 * soc - 2.011 * soc^2) * \Delta U_{Batt,}$$

$$_{mitt}(soc_0, T_{Batt}) \tag{5}$$

bezüglich eines Referenzzustandes $soc_0$ skaliert werden.

Unter Bezugnahme auf Fig. 3 sei bemerkt, dass die Mittel zur Feststellung einer die Startfähigkeit beeinflussenden Temperatur in Form eines Temperatursensors ausgebildet sein können. Die Mittel zur Berechnung oder Feststellung eines mittleren Spannungsabfalls der Starterbatterie während der Startphase sind insbesondere in Form einer Recheneinrichtung 31 ausgebildet, welche ebenfalls die Mittel zur Abschätzung der Startfähigkeit durch Vergleich des berechneten mittleren Spannungsabfalls mit einem Schwellwert enthalten können. Eine Batteriemanagement-Einrichtung, über welche der Batterieladezustand soc auf die Recheneinrichtung 31 gebbar ist, ist mit 32 bezeichnet.

## Patentansprüche

1. Verfahren zur Bestimmung der Startfähigkeit einer Starterbatterie eines Verbrennungsmotors mit folgenden Schritten:

   - Feststellung eines die Startfähigkeit beeinflussenden Ladezustands soc der Starterbatterie,
   - Feststellung einer die Startfähigkeit beeinflussenden Temperatur, insbesondere der Temperatur der Starterbatterie $T_{Batt}$,
   - Berechnung oder Feststellung eines mittleren Spannungsabfalls $\Delta U_{Batt, mitt}$ der Starterbatterie während einer Startphase, insbesondere während einer Durchdrehphase eines mit der Starterbatterie in Wirkverbindung stehenden Startermotors, und
   - Abschätzung der Startfähigkeit der Starterbatterie durch Vergleich des berechneten oder festgestellten mittleren Spannungsabfalls $\Delta U_{Batt, mitt}$ mit einem Schwellwert $U_{Batt, min}$.

2. Verfahren nach Anspruch 1, **dadurch gekennzeichnet, dass** der Vergleich des berechneten mittleren Spannungsabfalls mit dem Schwellwert unter zurhilfenahme einer Gleichung der Form

$$U_0(soc, T_{Batt}) - \Delta U_{Batt, mitt} (soc, T_{Batt}) = U_{Batt, min}$$

   durchgeführt wird, wobei soc der Batterieladezustand, $T_{Batt}$ die Batterietemperatur, $U_0$ die Ruhespannung der Batterie, $\Delta U_{Batt, mitt}$ der mittlere Spannungsabfall und $U_{Batt, min}$ die als Schwellenwert verwendbare Mindestspannung der Batterie zur Erreichung der Starterdrehzahl ist.

3. Verfahren nach einem der Ansprüche 1 oder 2, **dadurch gekennzeichnet, dass** der mittlere Spannungsabfall $\Delta U_{Batt, mitt}$ gemäß einer Gleichung der Form

$$\Delta U_{Batt, mitt} (soc, T_{Batt}) = 1/n * \Sigma (U_0(soc, T_{Batt}) - U_{Batt, i})$$

   zu Zeitpunkten i = 1 ... n berechnet wird.

4. Verfahren nach einem der vorstehenden Ansprüche, **dadurch gekennzeichnet, dass** die Ruhespannung $U_0$ der Batterie auf der Grundlage einer Gleichung der Form

$$U_0(soc, T_{Batt}) = 6*(1,88 + 0.247*soc + (T_{Batt} - 25)*0.23e\text{-}3)$$

ermittelt wird.

5. Verfahren nach einem der vorstehenden Ansprüche, **dadurch gekennzeichnet, dass** auf der Grundlage der ermittelten Werte für den mittleren Spannungsabfall $\Delta U_{Batt, mitt}$ ein Kennfeld des mittleren Spannungsabfalls in Abhängigkeit von der Batterietemperatur und dem Batterieladezustand erstellt und gespeichert wird.

6. Anordnung zur Bestimmung der Startfähigkeit einer Starterbatterie eines Verbrennungsmotors mit

- Mitteln (32) zur Feststellung eines die Startfähigkeit beeinflussenden Ladezustands soc der Starterbatterie,
- Mitteln (30) zur Feststellung einer die Startfähigkeit der Batterie beeinflussenden Temperatur, insbesondere der Temperatur $T_{Batt}$ der Starterbatterie,
- Mitteln (31) zur Berechnung oder Feststellung eines mittleren Spannungsabfalls $\Delta U_{Batt, mitt}$ der Starterbatterie während einer Startphase, insbesondere während einer Durchdrehphase eines mit der Starterbatterie in Wirkverbindung stehenden Startermotors, und
- Mitteln (31 zur Abschätzung der Startfähigkeit durch Vergleich des berechneten oder festgestellten mittleren Spannungsabfalls $\Delta U_{Batt, mitt}$ mit einem Schwellwert $\Delta U_{Batt, min}$.

**FIG. 1**

Ist Kaltstart beabsichtigt ? ⟍ 101

Ermittlung von Klemmenspannung oder Ruhespannung $U_0$ der unbelasteten Batterie ⟍ 102

Kaltstart einleiten ⟍ 103

Erreicht Startermotor Durchdrehphase ? ⟍ 104

Bilde Differenz aus Ruhespannung $U_0$ und aktueller Klemmenspannung $U_{Batt, i}$ zu Zeitpunkt i ( i = 1,....n ) ⟍ 105

Durchdrehphase des Startermotors beendet ?  Nein ⟍ 106

Ja

Berechne $U_{Batt, mitt} = \frac{1}{n} \sum ( U_0 - U_{Batt, i} )$ ⟍ 107

Vergleich $U_{Batt, mitt}$ mit Schwellwert ⟍ 108

Stelle Startfähigkeit der Batterie fest ⟍ 109

# FIG. 2

# FIG. 3